(19) Europäisches Patentamt

European Patent Office

Office européen des brevets

(11) Publication number: **0 291 062 B1**

(12) **EUROPEAN PATENT SPECIFICATION**

(45) Date of publication of patent specification: **15.07.92**   (51) Int. Cl.⁵: **G05F 3/24**

(21) Application number: **88107648.3**

(22) Date of filing: **11.05.88**

(54) Reference potential generating circuit.

(30) Priority: **15.05.87 JP 117113/87**

(43) Date of publication of application:
**17.11.88 Bulletin 88/46**

(45) Publication of the grant of the patent:
**15.07.92 Bulletin 92/29**

(84) Designated Contracting States:
**DE FR GB**

(56) References cited:
**EP-A- 0 029 231**
**US-A- 4 100 437**
**US-A- 4 318 040**
**US-A- 4 641 081**

**IBM TECHNICAL DISCLOSURE BULLETIN, vol. 16, no. 1, June 1973, pages 25-26, New York, US; F. GRUNBERG et al.: "A bias circuit compensated for threshold and supply variations"**

(73) Proprietor: **KABUSHIKI KAISHA TOSHIBA**
**72, Horikawa-cho Saiwai-ku**
**Kawasaki-shi Kanagawa-ken 210(JP)**

Proprietor: **Toshiba Micro-Computer Engineering Corporation**
**25-1, Ekimaehoncho Kawasaki-ku**
**Kawasaki-shi(JP)**

(72) Inventor: **Kiryu, Masakazu**
**4-7-3, Kugo-cho**
**Yokosuka-shi Kanagawa-Ken(JP)**
Inventor: **Koinuma, Hiroyuki**
**c/o Pat. Div., K.K. Toshiba,**
**1-1, Shibaura 1-chome, Minato-ku, Tokyo(JP)**
Inventor: **Suzuki, Kiminobu**
**c/o Pat. Div., K.K. Toshiba,**
**1-1, Shibaura 1-chome, Minato-ku, Tokyo(JP)**

(74) Representative: **Henkel, Feiler, Hänzel & Partner**
**Möhlstrasse 37**
**W-8000 München 80(DE)**

Rank Xerox (UK) Business Services

## Description

This invention relates to a reference potential generating circuit for generating a reference potential used for, for example, a sense amplifier in a semimemory device.

In general, a power-source-voltage dependent or threshold-voltage dependent circuit is widely used as a reference potential generating circuit. The power-source-voltage dependent reference potential generating circuit includes a plurality of load elements connected in series between the power source terminal and the ground terminal. The reference potential is derived from a connection node between the load elements. Resistors or depletion type insulated gate field effect transistors are used as the load elements. The reference potential is derived by dividing the voltage between the power source terminal and the ground terminal by using the load elements as voltage dividing resistors. In this case, however, the reference potential derived from the circuit is largely dependent on the power-source voltage. Thus, if the reference potential is dependent on the power-source voltage and when the power-source voltage varies, the reference potential fluctuates. Therefore, if the power-source voltage dependent reference potential generating circuit is used in a sense amplifier circuit, an error operation, for example, erroneous readout of memory data occurs when the power-source voltage varies. The power-source voltage may be varied by, for example, power-source voltage noise.

In contrast, a reference potential from the threshold-voltage dependent type reference potential generating circuit is less dependent on the power source voltage. The threshold-voltage dependent reference potential generating circuit functions to generate a reference potential by utilizing a threshold voltage of an insulated gate field effect transistor. That is, the reference potential generating circuit is constituted by connecting a depletion type insulated gate field effect transistor whose gate is grounded between the power source terminal and the series-connected load elements. The reference potential from the reference potential generating circuit is largely dependent on the threshold voltage of the transistor. Thus, the reference potential generated from the threshold-voltage dependent reference potential generating circuit will not greatly fluctuate even if the power source voltage varies, but tends to fluctuate according to variation in the threshold voltage of the transistor. Therefore, if the threshold-voltage dependent reference potential generating circuit is used in the sense amplifier circuit and the threshold voltage of the transistor is changed, then erroneous operations such as erroneous readout of memory data will occur. The threshold voltage of the transistor may be changed by variation in the transistor characteristics caused in the manufacturing process, for example.

As described above, the output potential of the power-source-voltage dependent reference potential generating circuit is little affected by the threshold voltage of the transistor but largely depends on the power source voltage, and the output potential of the threshold-voltage dependent reference potential generating circuit is little affected by the power source voltage but largely depends on the threshold voltage of the transistor. Therefore, the output potential of the conventional reference potential generating circuit will fluctuate according to the power source voltage noise or variation in the transistor characteristics caused in the manufacturing process.

In semiconductor memory devices, for example, if the power source voltage or signals externally supplied are little dependent on the power-source voltage and the threshold voltage of the transistor or the like, it is necessary to make the reference potential generated from the reference potential generating circuit less dependent on both the power-source voltage and the threshold voltage of the transistor. That is, the conventional reference potential generating circuit does not fully satisfy the requirement for preventing fluctuation of the reference potential when used in the sense amplifier circuit of the semiconductor memory device.

Prior art document US-A-4 100 437 discloses a MOS reference voltage circuit for providing a stable reference voltage. This MOS reference voltage circuit comprises an enhancement mode transistor having a first threshold voltage coupled to receive a first current and a depletion mode transistor having a second threshold voltage coupled to receive a second current, said second threshold voltage being different from said first threshold voltage. One of said first and second threshold voltages is subtracted from the other of said first and second threshold voltages in order to obtain a temperature stable reference voltage.

Further, prior art document US-A-4 318 040 discloses a power supply circuit for supplying current to a MOS depletion load transistor logic circuit for use in programmers for washing machines or controllers for tumble driers. The power supply circuit comprises a depletion MOS transistor having its drain-source path connected between first and second power supply rails. The conductivity of the depletion transistor is controlled by a long tail pair amplifier which compares a reference voltage derived from a source with a voltage derived from the second supply rail using a voltage divider. The voltage divider is constructed to compensate for the effects of process variations on parameters such as threshold voltage and thereby hold the voltage divider ratio substantially constant. The voltage divider comprises two enhancement MOS transistors connected in series between the second supply rail and ground and a current source in the form of a depletion MOS transistor and an enhancement transistor connected in series between the first and second supply rails. The gates of all the transistors are connected to a junction of the current source transistor and the drain of the transistor connected thereto. The voltage across the drain-source of this latter transistor varies with threshold voltage and is added to the voltage on the second rails.

It is an object of the present invention to provide a reference potential generating circuit which is less dependent on both the power source voltage and the threshold voltage of the transistor.

To solve this object the present invention provides a reference potential generating circuit as stated in claim 1.

With this construction, the influence of variation in the threshold voltage of the second insulated gate field effect transistor on the output potential can be suppressed by means of the first insulated gate field effect transistor. This is because the characteristics of variation in the threshold voltages of the first and second insulated gate field effect transistors are different from each other and the variations in the threshold voltages can be cancelled with each other. Further, the reference potential generating circuit is basically threshold-voltage dependent and is dependent on the threshold voltage of the second insulated gate field effect transistor so that it is less dependent on the power source voltage. Therefore, the reference potential generating circuit can be less dependent on both the power source voltage and the threshold voltage of the transistor.

This invention can be more fully understood from the following detailed description when taken in conjunction with the accompanying drawings, in which:

Fig. 1 is a circuit diagram of a reference potential generating circuit according to a first embodiment of this invention;

Fig. 2 is a diagram for explaining the dependency of a reference potential from the reference potential generating circuit of Fig. 1 on the power source voltage;

Fig. 3 is a diagram for explaining the dependency of a reference potential from the reference potential generating circuit of Fig. 1 on the threshold voltage;

Fig. 4 is a circuit diagram of an example of a circuit to be supplied with an output potential from the reference potential of Fig. 1; and

Figs. 5 to 9 are circuit diagrams showing reference potential generating circuits according to second to sixth embodiments of this invention.

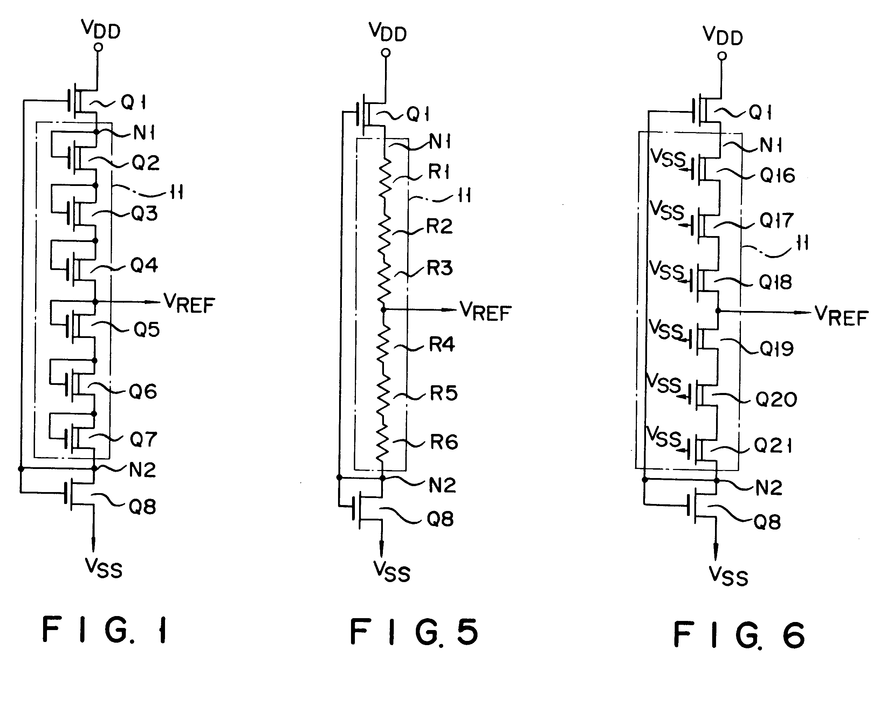

Fig. 1 shows a reference potential generating circuit according to a first embodiment of this invention. The drain-source paths or current paths of depletion type insulated gate field effect transistors Q1 to Q7 and the drain-source path or current path of enhancement type insulated gate field effect transistor Q8 are serially connected between power source terminal $V_{DD}$ andground terminal $V_{SS}$. The gate of transistor Q1 is connected to the gate and drain of transistor Q8. Further, the gate and drain of each of transistors Q2 to Q7 are connected to one another. Thus, transistors Q2 to Q7 constitute voltage dividing circuit 11 for dividing a voltage between the source of transistor Q1 and the drain of transistor Q8. Reference voltage $V_{REF}$ is derived from a connection node positioned between transistors Q4 and Q5.

There will now be described an operation of the circuit with the construction described above. When power source voltage $V_{DD}$ is applied, depletion type insulated gate field effect transistors Q1 to Q7 are gradually rendered conductive. As a result, the potential at a connection node or node N2 located between transistors Q7 and Q8 rises from ground potential $V_{SS}$ and is set stably at a level which is higher than the ground potential by the threshold voltage of enhancement type insulated gate field effect transistor Q8. Then, after power source voltage $V_{DD}$ has risen to a sufficiently high level, transistor Q1 is operated in a pentode operation mode. At this time, the potential at a connection node or node N1 between transistors Q1 and Q2 is set, by the threshold voltage of transistor Q1, at a level lower than the gate voltage of transistor Q1 or the potential at node N1. Reference potential $V_{REF}$ can be obtained by dividing a voltage between nodes N1 and N2 according to the ratio of the sum of conductive resistances of transistors Q2 to Q4 to the sum of conduction resistances of transistors Q5 to Q7.

With this construction, reference potential $V_{REF}$ depends on the threshold voltage of transistor Q1 and is therefore less dependent on power source voltage $V_{DD}$. Depletion type insulated gate field effect transistor Q1 and enhancement type insulated gate field effect transistor Q8 differ from one another in the variation mode of the threshold voltage. The voltage dividing ratio of voltage dividing circuit 11 is determined by the difference between the degrees of variation in the threshold voltages of transistors Q1 and Q8. Therefore, the influence of the threshold voltage of transistor Q1 which causes variation in the reference potential $V_{REF}$ can be suppressed. The voltage dividing ratio can be determined by, for example, changing the number of the series-connected transistors (Q2 to Q7) or deriving reference potential $V_{REF}$ from a different connection node.

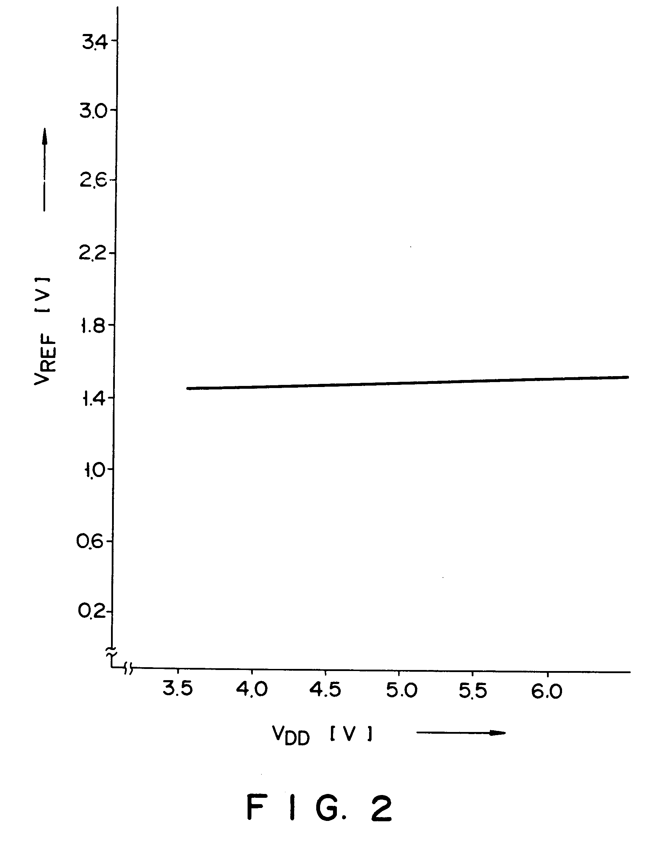

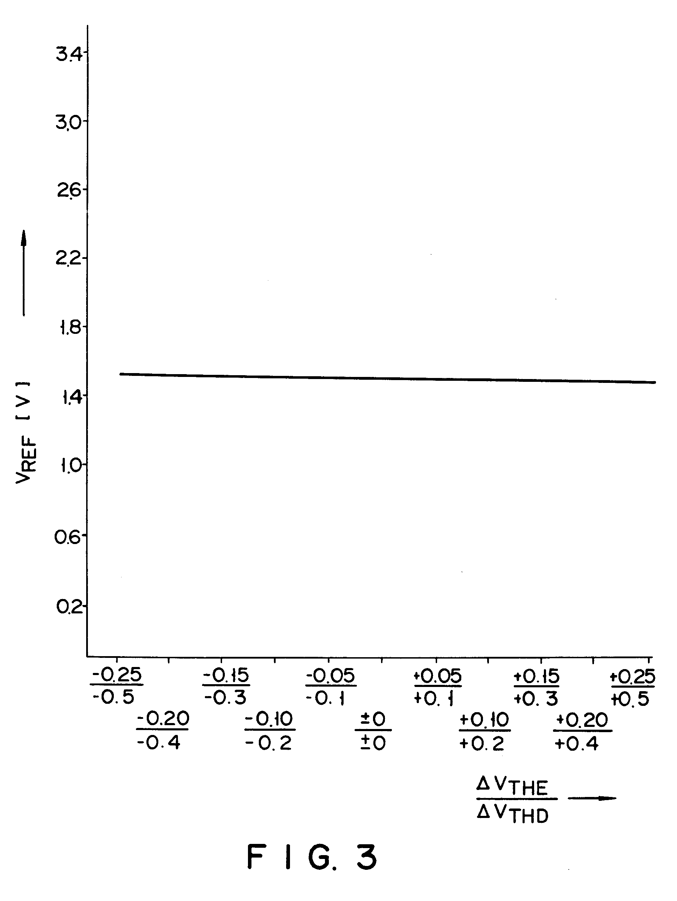

Fig. 2 shows the dependency of the reference voltage generating circuit shown in Fig. 1 on the power source voltage. Fig. 3 shows the dependency of the circuit of Fig. 1 on the threshold voltage in the case where variation $\Delta V_{THD}$ in the threshold voltage of the depletion type insulated gate field effect transistor is twice variation $\Delta V_{THE}$ in the threshold voltage of the enhancement type insulated gate field effect transistor. The dependence of the reference potential generating circuit of Fig. 1 on the power source voltage is as low as in the conventional threshold voltage dependent type reference potential generating circuit, and the dependence on the threshold voltage is as low as in the conventional power-source-voltage dependent reference voltage generating circuit. The reference voltage generating circuit thus provided is less dependent on both the power source voltage and the threshold voltage.

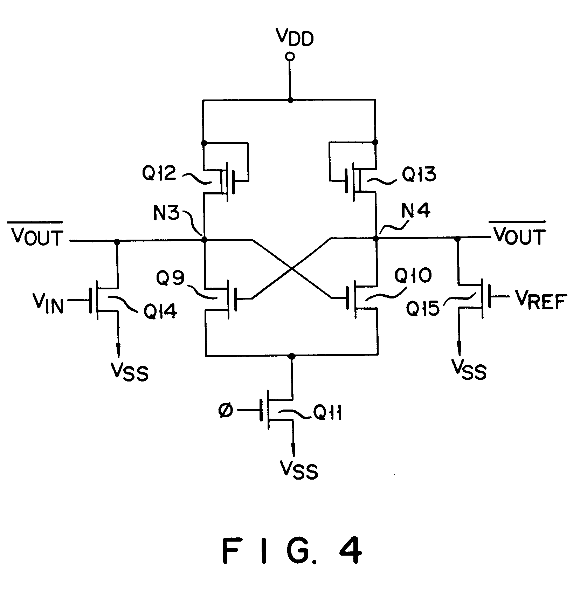

The reference potential generating circuit of Fig. 1 is used to generate reference potential $V_{REF}$ for a sense amplifier of Fig. 4, for example. Enhancement type insulated gate field effect transistors Q9 and Q10 of the sense amplifier constitute a differential input pair. Transistors Q9 and Q10 are connected to one another at one terminal and the gates thereof are cross-coupled to the other terminals of the respective transistors. The current path between the drain and source of enhancement type insulated gate field effect transistor Q11 is connected between a connection node between transistors Q9 and Q10 and ground terminal $V_{SS}$. The conduction state of transistor Q11 is controlled by signal $\phi$ for driving the sense amplifier and thus transistor Q11 functions as a current source. The current path between the drain and source of depletion type insulated gate field effect transistor Q12 is connected between the other terminal of transistor Q9 and power source terminal $V_{DD}$, and the gate of transistor Q12 is connected to power source terminal $V_{DD}$. The current path between the drain and source of depletion type insulated gate field effect transistor Q13 is connected between the other terminal of transistor Q10 and power source terminal $V_{DD}$, and the gate of transistor Q13 is connected to power source terminal $V_{DD}$. The drain and source of enhancement type insulated gate field effect transistor Q14 are respectively connected to a connection node (node N3) between transistors Q9 and Q12 and ground terminal $V_{SS}$. The conduction state of transistor Q14 is controlled by externally-supplied input signal $V_{IN}$. The drain and source of enhancement type insulated gate field effect transistor Q15 are respectively connected to a connection node (node N4) between transistors Q10 and Q13 and ground terminal $V_{SS}$. The conduction state of transistor Q15 is controlled by output voltage $V_{REF}$ from the reference potential generating circuit of Fig. 1. Memory cells and dummy cell which are not shown are respectively connected to node N3 and N4. Output signal $\overline{V_{OUT}}$ is derived from node N3, and output signal $V_{OUT}$ is derived from node N4.

In the circuit with the construction described above, externally supplied input signal $V_{IN}$ is determined to be at either a high ("H") level or a low ("L") level based on the following determination conditions (a) and (b).

(a) The sense amplifier determines externally supplied input signal $V_{IN}$ to be of an "H" level signal when input signal $V_{IN}$ is higher than 2.4 V.

(b) The sense amplifier determines externally supplied input signal $V_{IN}$ to be of an "L" level signal when input signal $V_{IN}$ is lower than 0.8 V.

In order to check whether or not the input signal meets the above condition, it is necessary to set a criterion or reference potential with respect to the "H" and "L" potential levels. When reference potential $V_{REF}$ used for the level determination is so set as to have margins in "H" and "L" level directions, it will be set at 1.6 V which is an intermediate potential between the lower limit potential 2.4 V of the "H" level and the upper limit potential 0.8 V of "L" level. Thus, reference potential $V_{REF}$ of 1.6 V is supplied from the reference potential generating circuit of Fig. 1 to the gate of transistor Q15.

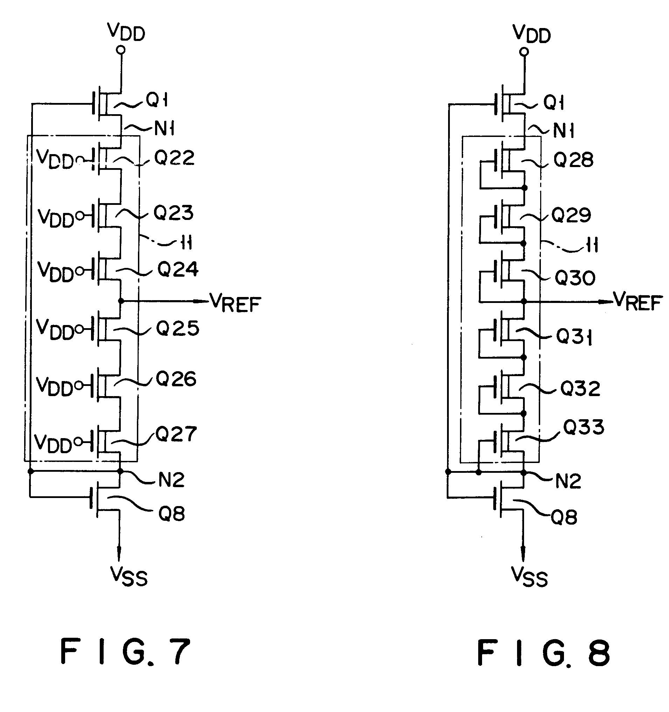

This invention has been described with reference to the embodiment, but this invention is not limited to the above embodiment and can be variously modified. For example, in the above embodiment, transistors Q2 to Q7 each having the drain and gate connected together are used as voltage dividing circuit 11 connected between nodes N1 and N2. However, it is possible to connect a plurality of resistors R1 to R6 in series between nodes N1 and N2 as shown in Fig. 5, and selectively derive reference potential $V_{REF}$ from a connection node between two of resistors R1 and R6.

Further, it is possible to connect depletion type insulated gate field effect transistors Q16 to Q21 whose gates are connected to ground terminal $V_{SS}$ between nodes N1 and N2 as shown in Fig. 6. It is also possible to connect depletion type insulated gate field effect transistors Q22 to Q27 whose gates are connected to power source terminal $V_{DD}$ between nodes N1 and N2 as shown in Fig. 7. In either case, the sane operability and effects as those of the former embodiment can be attained.

In the embodiment of Fig. 1, transistors Q2 to Q7 whose gate and drain are connected to one another are used, but it is possible to use depletion type insulated gate field effect transistors Q28 to Q33 whose source and gate are connected to one another as shown in Fig. 8.

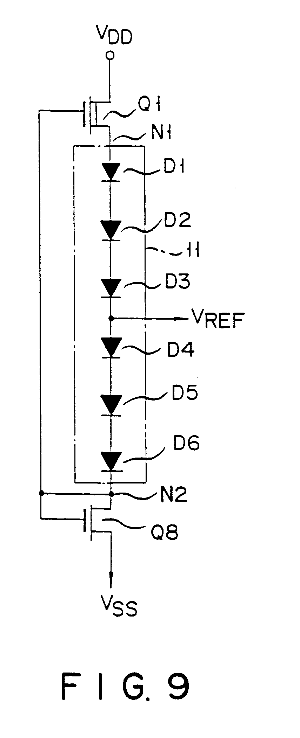

Fig. 9 shows another embodiment of this invention. As shown in Fig. 9, voltage dividing circuit 11 is constituted by series-connected diodes D1 to D6. With this construction, basically the same operability and effects as those of the former embodiment can be obtained.

In the circuits of Figs. 1, and 5 to 9, the gate potential of transistor Q1 is determined by the threshold voltage of transistor Q8.

As described above, according to this invention, a reference potential generating circuit can be provided which is less dependent on both the power source voltage and the threshold voltage of the transistor used.

## Claims

1. A reference potential generating circuit for dividing a voltage between a first potential supplying source ($V_{SS}$) and a second potential supplying source ($V_{DD}$) to generate an output voltage ($V_{REF}$) used as a reference voltage, said reference potential generating circuit comprising
   - first insulated gate field effect transistor (Q8) of an enhancement type having a source connected to said first potential supplying source ($V_{SS}$),
   - a second insulated gate field effect transistor (Q1) of a depletion type having a drain connected to said second potential supplying source ($V_{DD}$), and
   - voltage dividing means (11) connected between the drain of said first insulated gate field effect transistor (Q8) and the source of said second insulated gate field effect transistor (Q1), a dividing ratio of said voltage dividing means (11) being set in accordance with a difference in variation between a threshold voltage of said first insulated gate field effect transistor (Q8) and a threshold voltage of said second insulated gate field effect transistor (Q1) thereby to compensate for an influence of the variation in the threshold voltages of said first and second insulated gate field effect transistors (Q8, Q1) on the output voltage ($V_{REF}$), characterized in that:
   - the gate of said second insulated gate field effect transistor (Q1) is connected to;
   - the drain and the gate of said first insulated gate field effect transistor (Q8).

2. A reference potential generating circuit according to claim 1, characterized in that said first potential supplying source is a ground terminal ($V_{SS}$) and said second potential supplying source is a power source ($V_{DD}$).

3. A reference potential generating circuit according to claim 1, characterized in that said voltage dividing means (11) includes a plurality of depletion type insulated gate field effect transistors (Q2 to Q7) which are serially connected between the drain of said first insulated gate field effect transistor (Q8) and the source of said second insulated gate field effect transistor (Q1) and each of which has a drain and a gate which are connected to one another, and the output voltage ($V_{REF}$) is derived from a connection node positioned between two of said depletion type insulated gate field effect transistors (Q2 to Q7).

4. A reference potential generating circuit according to claim 1, characterized in that said voltage dividing means (11) includes a plurality of resistors (R1 to R6) which are serially connected between the drain of said first insulated gate field effect transistor (Q8) and the source of said second insulated gate field effect transistor (Q1), and the output voltage ($V_{REF}$) is derived from a connection node positioned between two of said resistors (R1 to R6).

5. A reference potential generating circuit according to claim 1, characterized in that said voltage dividing means (11) includes a plurality of depletion type insulated gate field effect transistors (Q16 to Q21) which are serially connected between the drain of said first insulated gate field effect transistor (Q8) and the source of said second insulated gate field effect transistor (Q1) and each of which has a gate connected to the ground terminal ($V_{SS}$) so as to be set in a conductive state, and the output voltage ($V_{REF}$) is derived from a connection node positioned between two of said depletion type insulated gate field effect transistors (Q16 to Q21).

6. A reference potential generating circuit according to claim 1, characterized in that said voltage dividing means (11) includes a plurality of depletion type insulated gate field effect transistors (Q22 to Q27) which are serially connected between the drain of said first insulated gate field effect transistor (Q8) and the source of said second insulated gate field effect transistor (Q1) and each of which has a gate connected to a power source ($V_{DD}$) so as to be set in a conductive state, and the output voltage ($V_{REF}$) is derived from a connection node positioned between two of said depletion type insulated gate field effect transistors (Q22 to Q27).

7. A reference potential generating circuit according to claim 1, characterized in that said voltage dividing means (11) includes a plurality of depletion type insulated gate field effect transistors (Q28 to Q33) which are serially connected between the drain of said first insulated gate field effect transistor (Q8) and the source of said second insulated gate field effect transistor (Q1) and each of which has a source and a gate which are connected to one another, and the output voltage (V$_{REF}$) is derived from a connection node located between adjacent two of said depletion type insulated gate field effect transistors (Q28 to Q33).

8. A reference potential generating circuit according to claim 1, characterized in that said voltage dividing means (11) includes a plurality of diodes (D1 to D6) which are serially connected between the drain of said first insulated gate field effect transistor (Q8) and the source of said second insulated gate field effect transistor (Q1), and the output voltage (V$_{REF}$) is derived from a connection node located between adjacent two of said diodes (D1 to D6).

9. A reference potential generating circuit according to claim 1, characterized in that said reference potential generating circuit being constituted to generate a reference voltage (V$_{REF}$) for a sense amplifier.

**Revendications**

1. Un circuit de génération de potentiel de référence destiné à diviser une tension établie entre une première source fournissant un potentiel (V$_{SS}$) et une seconde source fournissant un potentiel (V$_{DD}$), pour générer une tension de sortie (V$_{REF}$) qui est utilisée à titre de tension de référence, ce circuit de génération de potentiel de référence comprenant :
   - un premier transistor à effet de champ à grille isolée (Q8) d'un type à enrichissement, ayant une source connectée à la première source fournissant un potentiel (V$_{SS}$),
   - un second transistor à effet de champ à grille isolée (Q1) d'un type à désertion, ayant un drain connecté à la seconde source fournissant un potentiel (V$_{DD}$), et
   - des moyens de division de tension (11), connectés entre le drain du premier transistor à effet de champ à grille isolée (Q8) et la source du second transistor à effet de champ à grille isolée (Q1), le rapport de division de ces moyens de division de tension (11) étant fixé conformément à la différence de variation entre une tension de seuil du premier transistor à effet de champ à grille isolée (Q8) et une tension de seuil du second transistor à effet de champ à grille isolée (Q1), pour compenser ainsi une influence sur la tension de sortie (V$_{REF}$) de la variation des tensions de seuil des premier et second transistors à effet de champ à grille isolée (Q8, Q1), caractérisé en ce que :
   - la grille du second transistor à effet de champ à grille isolée (Q1) est connectée au drain et à la grille du premier transistor à effet de champ à grille isolée (Q8).

2. Un circuit de génération de potentiel de référence selon la revendication 1, caractérisé en ce que la première source fournissant un potentiel est une borne de masse (V$_{SS}$) et la seconde source fournissant un potentiel est une source d'alimentation (V$_{DD}$).

3. Un circuit de génération de potentiel de référence selon la revendication 1, caractérisé en ce que les moyens de division de tension (11) comprennent un ensemble de transistors à effet de champ à grille isolée du type à désertion (Q2 à Q7) qui sont connectés en série entre le drain du premier transistor à effet de champ à grille isolée (Q8) et la source du second transistor à effet de champ à grille isolée (Q1), et chacun d'eux comporte un drain et une grille qui sont connectés ensemble, et la tension de sortie (V$_{REF}$) est obtenue sur un noeud de connexion se trouvant entre deux des transistors à effet de champ à grille isolée du type à désertion (Q2 à Q7).

4. Un circuit de génération de potentiel de référence selon la revendication 1, caractérisé en ce que les moyens de division de tension (11) comprennent un ensemble de résistances (R1 à R6) qui sont connectées en série entre le drain du premier transistor à effet de champ à grille isolée (Q8) et la source du second transistor à effet de champ à grille isolée (Q1), et la tension de sortie (V$_{REF}$) est obtenue sur un noeud de connexion qui se trouve entre deux des résistances précitées (R1 à R6).

5. Un circuit de génération de potentiel de référence selon la revendication 1, caractérisé en ce que les moyens de division de tension (11) comprennent un ensemble de transistors à effet de champ à grille isolée du type à désertion (Q16 à Q21) qui sont connectés en série entre le drain du premier transistor à effet de champ à grille isolée (Q8) et la source du second transistor à effet de champ à grille isolée (Q1), et chacun d'eux comporte une grille connectée à la borne de masse ($V_{SS}$) de façon à être placé dans un état de conduction, et la tension de sortie ($V_{REF}$) est obtenue sur un noeud de connexion se trouvant entre deux des transistors à effet de champ à grille isolée du type à désertion (Q16 à Q21).

6. Un circuit de génération de potentiel de référence selon la revendication 1, caractérisé en ce que les moyens de division de tension (11) comprennent un ensemble de transistors à effet de champ à grille isolée du type à désertion (Q22 à Q27) qui sont connectés en série entre le drain du premier transistor à effet de champ à grille isolée (Q8) et la source du second transistor à effet de champ à grille isolée (Q1), chacun d'eux comportant une grille qui est connectée à une source d'alimentation ($V_{DD}$), de façon à être placé dans un état de conduction, et la tension de sortie ($V_{REF}$) est obtenue sur un noeud de connexion qui se trouve entre deux des transistors à effet de champ à grille isolée du type à désertion (Q22 à Q27).

7. Un circuit de génération de potentiel de référence selon la revendication 1, caractérisé en ce que les moyens de division de tension (11) comprennent un ensemble de transistors à effet de champ à grille isolée du type à désertion (Q28 à Q33) qui sont connectés en série entre le drain du premier transistor à effet de champ à grille isolée (Q8) et la source du second transistor à effet de champ à grille isolée (Q1), chacun d'eux comportant une source et une grille qui sont connectées ensemble, et la tension de sortie ($V_{REF}$) est obtenue sur un noeud de connexion qui se trouve entre deux transistors adjacents parmi les transistors à effet de champ à grille isolée du type à désertion (Q28 à Q33).

8. Un circuit de génération de potentiel de référence selon la revendication 1, caractérisé en ce que les moyens de division de tension (11) comprennent un ensemble de diodes (D1 à D6) qui sont connectées en série entre le drain du premier transistor à effet de champ à grille isolée (Q8) et la source du second transistor à effet de champ à grille isolée (Q1), et la tension de sortie ($V_{REF}$) est obtenue sur un noeud de connexion qui se trouve entre deux diodes adjacentes (D1 à D6).

9. Un circuit de génération de potentiel de référence selon la revendication 1, caractérisé en ce que ce circuit de génération de potentiel de référence est conçu de façon à générer une tension de référence ($V_{REF}$) pour un amplificateur de lecture d'une mémoire.

**Patentansprüche**

1. Referenzspannungsgeneratorschaltung zum Aufteilen einer Spannung zwischen einer ersten Potentialspeisequelle ($V_{SS}$) und einer zweiten Potentialspeisequelle ($V_{DD}$) zwecks Erzeugung einer als Bezugs- oder Referenzspannung benutzten Ausgangsspannung ($V_{REF}$), wobei die Referenzspannungsgeneratorschaltung umfaßt:
   - einen ersten Isolierschicht-Feldeffektransistor (Q8) eines Anreicherungstyps, dessen Source mit der ersten Potentialspeisequelle ($V_{SS}$) verbunden ist,
   - einen zweiten Isolierschicht-Feldeffektransistor (Q1) eines Verarmungstyps, dessen Drain mit der zweiten Potentialspeisequelle ($V_{DD}$) verbunden ist, und
   - eine zwischen Drain des ersten Isolierschicht-Feldeffektransistors (Q8) und Source des zweiten Isolierschicht-Feldeffektransistors (Q1) geschaltete Spannungsteilereinheit (11), deren Teilungsverhältnis entsprechend einer Differenz in der Änderung oder Variation zwischen einer Schwellenspannung des ersten Isolierschicht-Feldeffektransistors (Q8) und einer Schwellenspannung des zweiten Isolierschicht-Feldeffektransistors (Q1) eingestellt ist, um damit einen Einfluß der Änderung oder Variation in den Schwellenspannungen der ersten und zweiten Isolierschicht-Feldeffektransistoren (Q8, Q1) auf die Ausgangsspannung ($V_{REF}$) zu kompensieren, dadurch gekennzeichnet, daß
   - das Gate des zweiten Isolierschicht-Feldeffektransistors (Q1) mit Drain und Gate des ersten Isolierschicht-Feldeffektransistors (Q8) verbunden ist.

2. Referenzspannungsgeneratorschaltung nach Anspruch 1, dadurch gekennzeichnet, daß die erste Potentialspeisequelle ein Masseanschluß ($V_{SS}$) und die zweite Potentialspeisequelle eine Stromquelle ($V_{DD}$) sind.

3. Referenzspannungsgeneratorschaltung nach Anspruch 1, dadurch gekennzeichnet, daß die Spannungsteilereinheit (11) eine Anzahl von Verarmungstyp-Isolierschicht-Feldeffektransistoren (Q2 - Q7) aufweist, die in Reihe zwischen Drain des ersten Isolierschicht-Feldeffektransistors (Q8) und Source des zweiten Isolierschicht-Feldeffektransistors (Q1) geschaltet sind und die jeweils Drain und Gate, welche zusammengeschaltet sind, aufweisen, und die Ausgangsspannungen ($V_{REF}$) von einem Verbindungsknotenpunkt zwischen zwei der Verarmungstyp-Isolierschicht-Feldeffektransistoren (Q2 - Q7) abnehmbar ist.

4. Referenzspannungsgeneratorschaltung nach Anspruch 1, dadurch gekennzeichnet, daß die Spannungsteilereinheit (11) eine Anzahl von Widerständen (R1 - R6) aufweist, die in Reihe zwischen Drain des ersten Isolierschicht-Feldeffektransistors (Q8) und Source des zweiten Isolierschicht-Feldeffektransistors (Q1) geschaltet sind, und die Ausgangsspannung ($V_{REF}$) von einem Verbindungsknotenpunkt zwischen zwei der Widerstände (R1 - R6) abnehmbar ist.

5. Referenzspannungsgeneratorschaltung nach Anspruch 1, dadurch gekennzeichnet, daß die Spannungsteilereinheit (11) eine Anzahl von Verarmungstyp-Isolierschicht-Feldeffektransistoren (Q16 - Q21) aufweist, die in Reihe zwischen Drain des ersten Isolierschicht-Feldeffektransistors (Q8) und Source des zweiten Isolierschicht-Feldeffektransistors (Q1) geschaltet sind und die jeweils ein mit dem Masseanschluß ($V_{SS}$) verbundenes Gate, so daß sie in einen Durchschaltzustand gesetzt sind, aufweisen, und die Ausgangsspannung ($V_{REF}$) von einem Verbindungsknotenpunkt zwischen zwei der Verarmungstyp-Isolierschicht-Feldeffektransistoren (Q16 - Q21) abnehmbar ist.

6. Referenzspannungsgeneratorschaltung nach Anspruch 1, dadurch gekennzeichnet, daß die Spannungsteilereinheit (11) eine Anzahl von Verarmungstyp-Isolierschicht-Feldeffektransistoren (Q22 - Q27) aufweist, die in Reihe zwischen Drain des ersten Isolierschicht-Feldeffektransistors (Q8) und Source des zweiten Isolierschicht-Feldeffektransistors (Q1) geschaltet sind und die jeweils ein mit einer Stromquelle ($V_{DD}$) verbundenes Gate, so daß sie in einen Durchschaltzustand gesetzt sind, aufweisen, und die Ausgangsspannung ($V_{REF}$) von einem Verbindungsknotenpunkt zwischen zwei der Verarmungstyp-Isolierschicht-Feldeffektransistoren (Q22 - Q27) abnehmbar ist.

7. Referenzspannungsgeneratorschaltung nach Anspruch 1, dadurch gekennzeichnet, daß die Spannungsteilereinheit (11) eine Anzahl von Verarmungstyp-Isolierschicht-Feldeffektransistoren (Q28 - Q33) aufweist, die in Reihe zwischen Drain des ersten Isolierschicht-Feldeffektransistors (Q8) und Source des zweiten Isolierschicht-Feldeffektransistors (Q1) geschaltet sind und die jeweils Source und Gate, die zusammengeschaltet sind, aufweisen, und die Ausgangsspannung ($V_{REF}$) von einem Verbindungsknotenpunkt zwischen zwei benachbarten der Verarmungstyp-Isolierschicht-Feldeffektransistoren(Q28 - Q33) abnehmbar ist.

8. Referenzspannungsgeneratorschaltung nach Anspruch 1, dadurch gekennzeichnet, daß die Spannungsteilereinheit (11) eine Anzahl von Dioden (D1 - D6) aufweist, die in Reihe zwischen Drain des ersten Isolierschicht-Feldeffektransistors (Q8) und Source des zweiten Isolierschicht-Feldeffektransistors (Q1) geschaltet sind, und die Ausgangsspannung ($V_{REF}$) von einem Verbindungsknotenpunkt zwischen zwei benachbarten Dioden (D1 - D6) abnehmbar ist.

9. Referenzspannungsgeneratorschaltung nach Anspruch 1, dadurch gekennzeichnet, daß die Referenzspannungsgeneratorschaltung ausgelegt ist zur Erzeugung einer Referenzspannung ($V_{REF}$) für einen Meß- oder Leseverstärker.

EP 0 291 062 B1

V_DD

Q1

N1

Q2

11

Q3

Q4

→ V_REF

Q5

Q6

Q7

N2

Q8

V_SS

F I G. 1

V_DD

Q1

N1

R1

11

R2

R3

→ V_REF

R4

R5

R6

N2

Q8

V_SS

F I G. 5

V_DD

Q1

N1

V_SS Q16

V_SS Q17

11

V_SS Q18

→ V_REF

V_SS Q19

V_SS Q20

V_SS Q21

N2

Q8

V_SS

F I G. 6

# F I G. 2

F I G. 3

F I G. 4

F I G. 7

F I G. 8

F I G. 9